# EUROPEAN PATENT APPLICATION

(11) **EP 2 096 817 A1**
(43) Date of publication of application: **02.09.2009**
(21) Application number: 08300120.6
(22) Date of filing: 28.02.2008
(51) Int. Cl.: H04L 27/26, H04B 1/12, H04B 1/10

(54) **Impulsive noise cancellation in OFDM systems**

(71) Applicant: THOMSON Licensing, 92100 Boulogne-Billancourt (FR)
(72) Inventor: Zhang, Xiaoxin, 100871, BEIJING (CN); Zhao, Yuping, 1000871, BEIJING (CN); Zopu, Li, 100088, BEIJING (CN)
(74) Representative: Ruellan-Lemonnier, Brigitte

(57) **Abstract**

Methods and receivers for cancelling impulsive noise in Orthogonal Frequency Division Multiplexed (OFDM) wireless communications networks. The energy parameters of the impulsive noise in the signal are determined, and if the parameters exceed a threshold, the noise is cancelled from the signal by zeroing the pulses that exceed the threshold. The energy parameters and cancelling are performed in the time domain.

## Description

### Field of the Invention

This invention relates generally to noise cancellation in Orthogonal Frequency Division Multiplexing (OFDM) receivers. More specifically, the invention relates to impulsive noise cancellation (INC) techniques in OFDM receivers for wireless communications.

### Background of the Invention

OFDM is a very promising modulation and access scheme for wideband wireless communications networks, and other types of communication networks. It has been adopted by many international standards bodies such as DVB (Digital Video Broadcasting) and wireless LAN (Local Area Network). It is a promising technique for the future wideband wireless communication systems, such as digital television broadcasting and fourth generation wireless networks.

Impulsive noise widely exists in wireless communications environments and other communications environments where noise is prevalent and tends to occur in bursts. As used herein and as understood by those skilled in the art, impulsive noise is generally wide bandwidth, random noise having at least two common properties. The first property is that its energy is concentrated into short periods. The second property is that its energy is much higher than that of the background noise. Moreover, it is generally understood that impulsive noise is composed of high energy pulses.

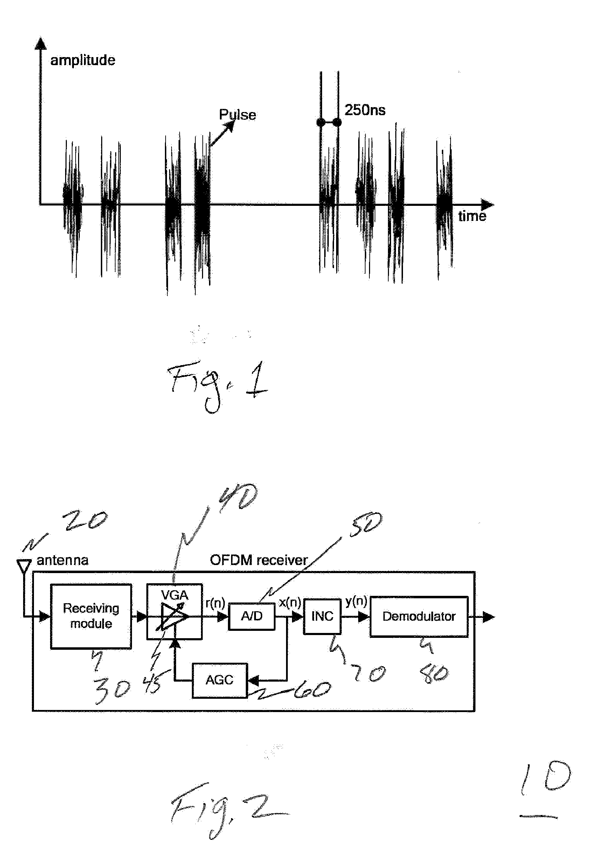

Referring to Fig. 1, an example of a signal having impulsive noise therein is shown. Each pulse has a fixed duration of about 250 ns. It is also understood by those skilled in the art that the signal in a pulse has a Gaussian distribution. As can be seen, the energy of a pulse is much higher than that of the background noise, and the impulsive noise has a very wide bandwidth in the frequency domain. Since each OFDM receiver has a receiving filter with limited bandwidth, the filtered impulsive noise will be expanded in the time domain.

OFDM systems are less sensitive to impulsive noise than single carrier systems. However, impulsive noise with high energy and arrival probability can significantly affect the performance of OFDM systems. Therefore, an INC technique is usually necessary in an OFDM system. Such techniques detect the position of impulsive noise and remove it from the received OFDM signal. There are two basic kinds of methods to implement INC techniques. One is in the general class of time domain techniques, and the other is in the general class of frequency domain techniques. The typical methods for INC in the time domain are Blanking-Nonlinearity and Limiting-Nonlinearity. The advantage of time domain INC methods is that they have low complexity and are easy to implement. However, the disadvantage of time domain techniques is that they cannot detect the position of impulsive noise correctly, especially when considering the clipping effect introduced by the A/D (Analog to Digital) converter which is generally found in the receiver.

There are many known methods for implementing INC in the frequency domain. One well-known method consists of detecting the position of the impulsive noise in the signal and then estimating the value of the impulsive noise by using the frequency signal after demodulation. The advantage of frequency domain INC methods is that they can detect the impulsive noise position correctly and estimate their values accurately. However, frequency domain methods are very complex and monopolize resources. Moreover, OFDM receivers contain a receiving filter with limited bandwidth, which is much narrower than the bandwidth of impulsive noise. Therefore, the receiving filter will introduce distortion to impulsive noise. However, none of the existing INC methods have considered this affect, and this deleteriously influences the implementation of prior INC methods in OFDM receivers. Therefore, none of the existing INC methods is optimal.

### Summary of the Invention

The aforementioned problems are solved and long-felt needs met, by methods and receivers provided in accordance with the present invention. Preferably, signals having impulsive noise therein are received. More preferably, in the time domain a position of the impulsive noise in the signal is detected, and the impulsive noise is cleared from the signal based on the position of the impulsive noise.

### Brief Description of the Drawings

Figure 1 is a graph of time domain impulsive noise.
Figure 2 is a block diagram of a preferred OFDM receiver of the present invention.
Figure 3 is a circuit diagram of an exemplary INC circuit that may be used in conjunction with the present invention.
Figure 4 is a flow chart of a preferred method in accordance with the present invention.
Figure 5 is a flow chart of yet a further preferred method in accordance with the present invention.
Figure 6 is a flow chart describing a preferred method for determining a threshold.
Figure 7 is a flow chart describing a preferred method for applying a detection rule.
Figure 8 shows a pulse of impulsive noise before and after filtering.
Figure 9 describes a signal x(n) both with, and without, a pulse of impulsive noise (IN).

### Detailed Description of Preferred Embodiments

Referring to Fig. 2, a block diagram of an OFDM receiver 10 in accordance with the present invention is shown. It will be appreciated by those with skill in the art that the present receivers and methods of the invention are particularly applicable to OFDM systems and the OFDM environment. However, the present invention is applicable to other modulation/demodulation noise cancellation schemes, and is not limited to the OFDM environment. Generally, the present invention will find use in any environment where impulsive noise is a problem. The invention will be described throughout with reference to the OFDM environment.

The received time domain OFDM signals from antenna 20 are passed through a receiving module or circuit 30 and amplified by a Variable Gain Amplifier (VGA) 40 to obtain signal r(n). The receiving module 30 is of a conventional type, having a design that is readily apparent to those skilled in the art, for example. Similarly, the VGA 40 is also conventional, and typically comprises a variable amplifier 45 which is adjustable to provide a variable gain function for receiver 10. The signal r(n) is transmitted to an A/D converter 50 which digitizes r(n) to obtain a digital signal x(n). An AGC (Automatic Gain Control) circuit 60 is fed by the A/D converter 50 to adjust the gain of the VGA 40. Antenna 20 and receiving module 30 function in receiver 10 to receive a source of signal that is expected to have impulsive noise therein. It will be appreciated by those skilled in art that other elements of receiver 10 can also be considered as acting in conjunction with the antenna 20 and receiving module 30 to receive the OFDM signals, for example the VGA 40 or AGC circuit 50. Any network that acts in a receiver to receive OFDM signals can function in accordance with the invention to receive OFDM signals, and equivalent networks are intended to be within the scope of the present invention.

As AGC circuit 60 provides gain control to the receiver 10, the signal x(n) is transmitted to an INC circuit 70 to remove impulsive noise and to obtain signal y(n). Signal y(n) is a substantially filtered, OFDM signal having the impulsive noise substantially removed therefrom. Signal y(n) is conventionally demodulated by demodulator 80 to be output for use as is generally desired.

INC circuit 70 provides impulsive noise cancellation to receiver 10 in an improved manner not previously known in the art. Generally, the inventive INC circuits 70, and methods therefore, provide impulsive noise cancellation to OFDM receivers by implementing a new and inventive technique herein defined as a "Pulse Blanking Algorithm" (PBA). The PBA of the present invention preferably detects a position of impulsive noise in a sample of the received time domain OFDM signals, and clears or otherwise cancels those samples with impulsive noise to zero.

In a preferred embodiment, the PBAs of the present invention employ a signal threshold and a detection rule to detect the position of each pulse of impulsive noise in the signal. The INC circuits 70 of the invention, and methods therefore, clear these samples with impulsive noise to zero to effectively remove the noise from the signals so that the signals can be transmitted for use to other parts of a communications network efficiently and with high integrity. The inventive PBAs perform much better than the conventional INC methods in the time domain with generally the same or similar resources. The inventive methods are less complex, and do not monopolize resources as compared to prior methods.

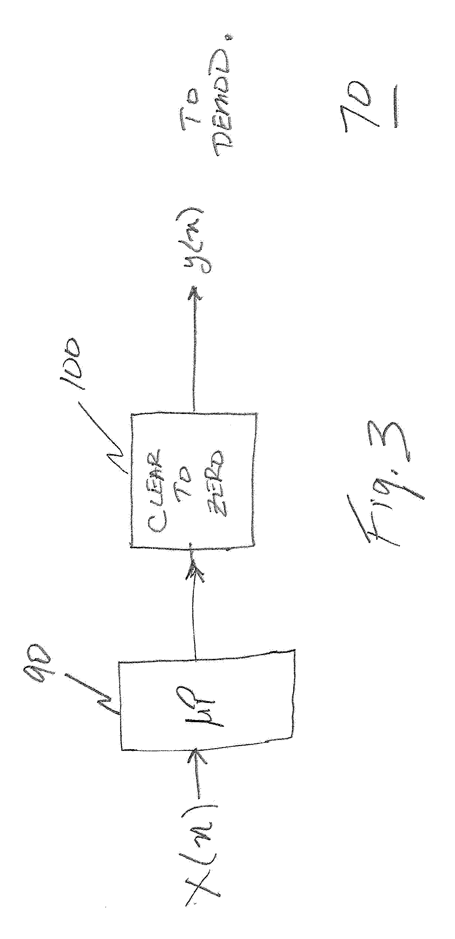

Referring now to Fig. 3, an exemplary circuit for implementing INC circuit 70 in accordance with the invention is shown. It will be appreciated by those skilled in the art that, in the time domain, the OFDM signals having impulsive noise therein can be modeled as signals having bursts of high energy noise. As described herein, it is desirable to remove this high energy noise from the signals to provide signals with high integrity and quality. Many different types of circuits can be designed to accomplish this result. As an example of such a circuit, and not intending to limit the invention in any way, INC circuit 70 preferably comprises an integrated circuit 90 which can be programmable to provide parameters for performing PBAs in accordance with the invention.

It will be further recognized by those skilled in the art that the integrated circuit 90 can be implemented in firmware, software or other hardware as is desired, and as is conventionally known. In fact, the functions of integrated circuit 90 can be provided by conventional circuitry known to skilled artisans such that other than integrated circuit embodiments are within the scope of the invention. Generally speaking, the described circuits 90 are adapted to provide control of parameters of the signal input to the INC circuit 70 so as to effectively accomplish PBAs that will be described in more detail below. Circuit 90 can be a microprocessor (µP), or can be microprocessor based or controlled.

Preferably, integrated circuit 90 is designed to provide a signal threshold and a detection rule to detect the position of each pulse of impulsive noise in the signal. The threshold can be a predetermined threshold set by a user of the receiver, or pre-set as a factory setting. The detection rule is any proper rule that will effectively allow the receiver to set the impulsive noise to zero, examples of which are described in more detail herein.

Still more preferably, the INC circuit 70 comprises a circuit 100, which accepts input signals that are output from integrated circuit 90 and which provide thresholds and other parameters to implement the proper detection rules to accomplish PBAs of the present invention. Generally speaking, and not intending to limit the invention in any way, circuit 100 provides capability to clear the digital signal of the noise by giving digital filter functionality to the INC circuit 70 so as to remove the impulsive noise from the OFDM signals in accordance with the PBAs of the invention. It will be recognized by those skilled in the art that circuit 100 can comprise a register adapted to store digital representations of at least the impulsive noise. In accordance with inventive PBAs, the register is cleared or otherwise cancelled of the noise by setting the register elements or bit positions to zero when the conditions described herein are met.

Circuit 100 preferably comprises digital circuit element responsive to parameters provided by integrated circuit 90, or which can be insensitive thereto, depending on the desired response required of the receivers of the present invention. It should be appreciated that the circuit of Fig. 3 is merely an example of a type of circuit that can be employed to implement the PBAs of the present invention. Therefore, this embodiment should not be construed as limiting the invention, and other kinds of circuits are within the scope hereof. Any circuit that is adapted to remove impulsive noise can be substituted to perform this function to implement the PBAs of the present invention.

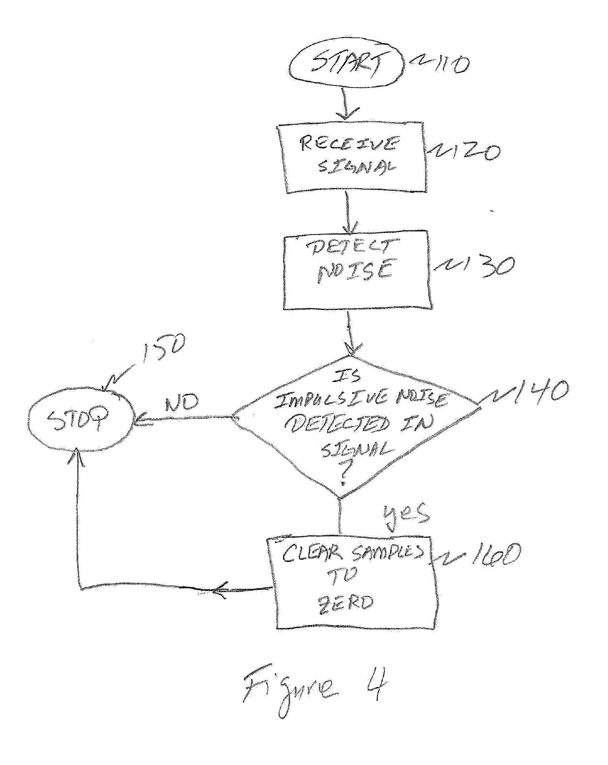

As will be appreciated, the present receivers and methods therefore will be generally realizable in software or firmware, or even in hardware implementations of such code. Referring now to Fig. 4, a flow chart of an exemplary software method of the present invention is shown. The method starts at 110 wherein the method is initiated by the receiver or other hardware on which the software will be run. At step 120, the OFDM signals are received, and at step 130, impulsive noise in the signal is detected. Preferably, it is determined at step 140 whether impulsive noise components have been detected in the signal. If not, then at step 150 the method stops and the signal otherwise passes to the demodulator for conventional demodulation. In this case, no impulsive noise was found in the signal, and only background noise, or in fact no noise components, were detected. If however impulsive noise has been detected, then at step 160 the PBAs of the present invention clear the samples of noise in the signals to zero, thereby cleaning the signals and allowing conventional demodulation to occur more efficiently and accurately.

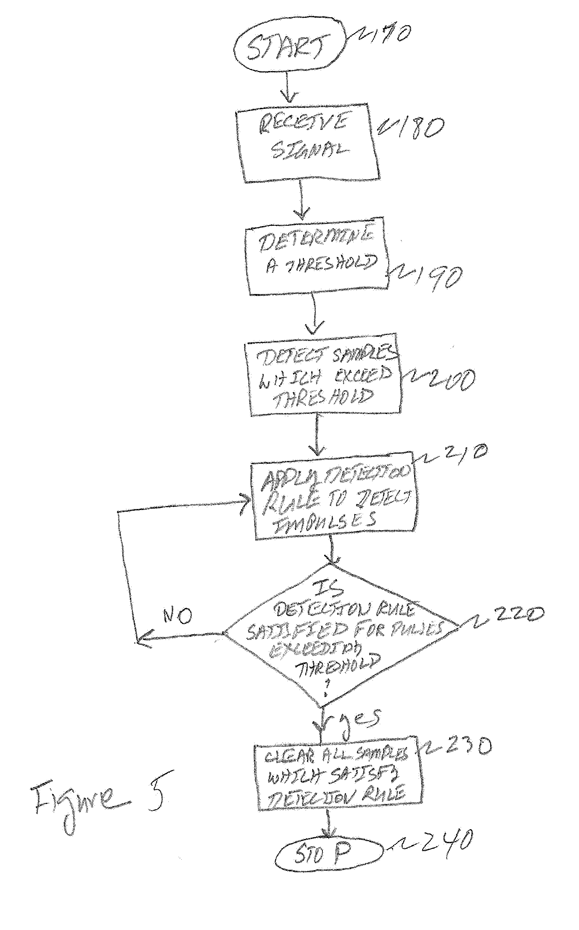

Fig. 5 describes yet a further preferred embodiment of software for implementing PBAs of the present invention. This method begins at step 170, and at step 180 the OFDM signals are received. At step 190, a threshold for the noise is determined or otherwise examined. Once the threshold is understood, determined or examined, at step 200 samples are detected in the signal which exceed the threshold. At step 210, a detection rule is then applied to detect the impulses, and it is determined at step 220 whether the detection rule for each sample is satisfied for pulses which exceed the threshold. If it is determined that the detection rule is not satisfied, then the method returns to step 210 for further examination of the sample pulses in the signal and the application of the proper detection rule.

However, if it has been determined by step 220 that the detection rule was satisfied for at least one pulse in the signal, than the method proceeds to step 230 wherein the signal is cleared of all pulses which have satisfied the detection rule. In this fashion, the received OFDM signals are cleared of impulsive noise by implementation of PBAs provided in accordance with the present invention. The method stops at step 240 and the signals which have been cleared of their impulsive noise spikes can then be conventionally demodulated.

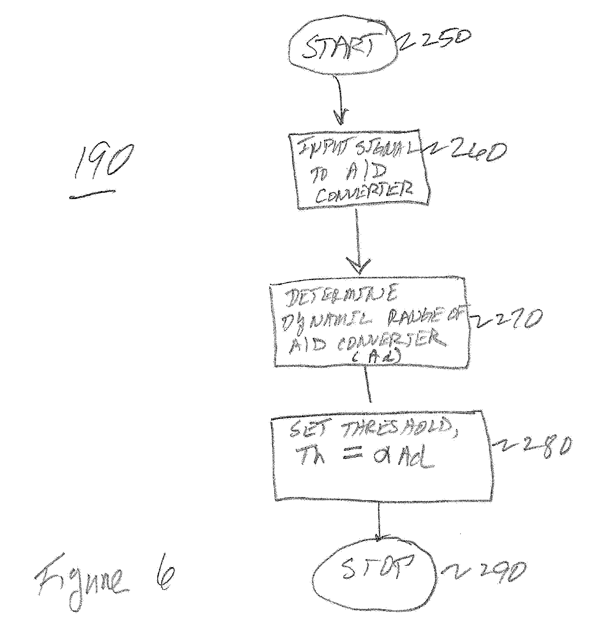

Referring now to Figures 6, 8 and 9, an exemplary embodiment of step 190 wherein a threshold is determined or otherwise examined is described. The method begins at step 250 and at step 260 the OFDM signals are input to the A/D 50. It is then desired at step 270 to determine the dynamic range (Ad) of the A/D 50. Once the Ad is so determined, at step 280 it is further desired to set the threshold Th. In a preferred embodiment, Th is set equal to αAd, wherein α is a constant that is adjustable, and which can be predetermined, or which can otherwise be programmable by a user or at the factory. The method then stops at step 290.

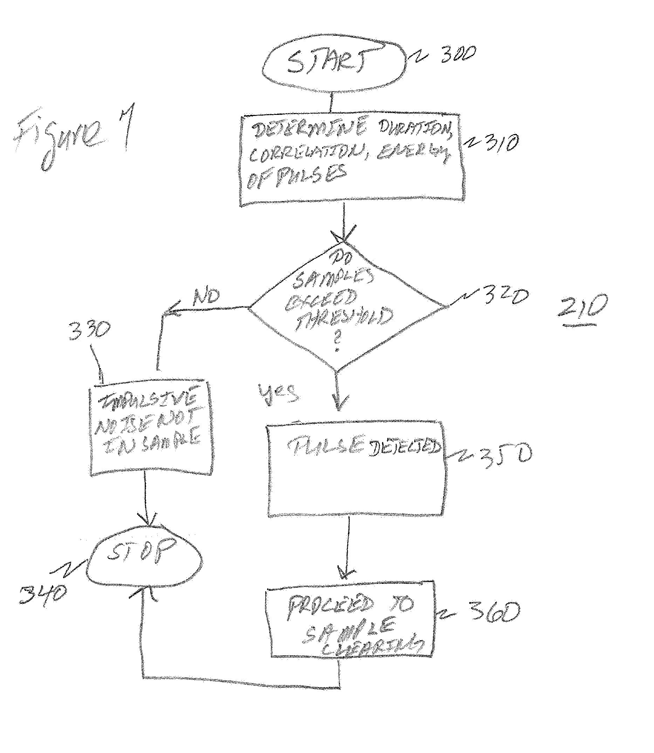

In Fig. 7, a preferred method for applying a proper detection rule 210 in accordance with the present invention is illustrated. Preferably, the method starts at step 300, and at step 310 parameters such as the duration, correlation and energy of pulses in the OFDM signals are determined. It is then determined at step 320 whether the samples exceed the threshold, Th, based on the determined parameters of step 310. If it is determined that the samples do not exceed the threshold Th, then at step 330 impulsive noise is deemed not to be in the signal and the method stops at step 340. It will be appreciated that other detection parameters may be employed in the inventive detection rules. Generally, these detection parameters can be parameters relating to the quality of the signal and the impulsive noise and that can be used to quantify the thresholds as described herein.

If, however, it is determined at step 320 that the samples exceed the threshold Th, then the method proceeds to step 350 wherein it is deemed that an impulsive noise pulse has been detected and at step 360 the samples are cleared by setting these pulses to zero. The method then stops again at step 340.

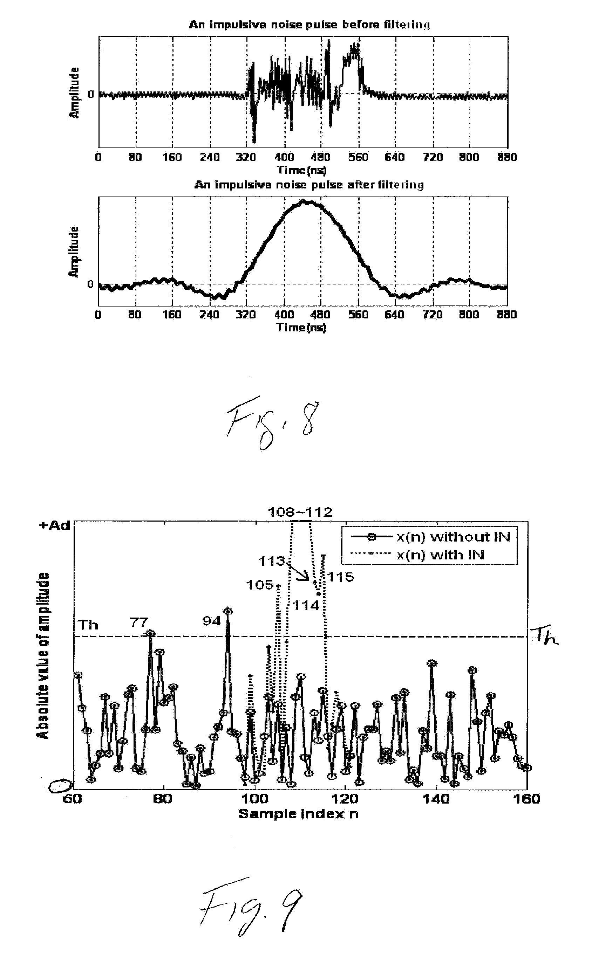

Referring to Figs. 8 and 9, it can be seen that OFDM signals in the time domain have substantially a Gaussian distribution. Due to this distribution, when AGC 60 adjusts signal r(n) it must fit the dynamic range of the A/D converter 50. Since impulsive noise is a kind of short duration event, it usually does not affect AGC 60.

In this instance and considering that impulsive noise is high energy, Fig. 9 shows signal x(n) with, and without, a pulse of impulsive noise. Here, the range of the A/D converter 50 is from -Ad to +Ad. By setting the range of the A/D 50, the PBAs of the invention employ a threshold Th to detect most samples containing impulsive noise while also detecting a number of samples without impulsive noise by mistake. The inventive methods employ a proper detection rule to separate the samples with impulsive noise from those without impulsive noise according to the property of a pulse. For instance, since each pulse has certain duration, high correlation and high energy because of the bandwidth limitation effect introduced by the receiving filter, and the OFDM signal in the time domain has almost Gaussian distribution and low correlation, one example of a rule as described above with respect to the various flow charts is that if there are continuous samples exceeding the threshold Th, a pulse is detected, or else, the sample does not contain impulsive noise even though spikes therein exceed Th. Finally, the inventive PBAs clear all the samples with impulsive noise to zero. It will be further appreciated that this rule is only an example, and there are many other possible rules which may be employed in accordance with the present invention.

PBAs of the present invention will be particularly useful in DVB systems. In the context of a DVB system the present methods will determine a proper threshold Th according to the dynamic range of the A/D converter, Ad, as described above. It has been found in a presently preferred embodiment for DVB, for example, α = 0.57 such that Th=0.57xAd. Using this value, the threshold Th detects all the x(n) samples having amplitudes that exceed Th. For instance, samples 77, 94, 105 and 108 - 115 are detected as is shown in Fig. 9.

A preferable detection rule to detect each pulse of impulsive noise can then be that a pulse will be deemed detected if there are four samples exceeding the threshold Th in every four continuous samples, or else there is no pulse detected. Using this exemplary rule to check all the detected samples to find out the samples with impulsive noise it can be seen that, for example, samples 77, 94 and 105 are wrongly detected, and samples 108 - 115 are correctly detected with impulsive noise and are considered to have impulsive noise therein. Then, in order to implement the PBA, all the samples with impulsive noise are cleared to zero. Thus, samples 108 - 115 are cleared from the signal, while samples 77, 94 and 105 are not cleared from the signal.

The proposed INC methods thus effectively remove impulsive noise in the time domain. Different from the existing INC methods, the PBAs described herein take advantage of the high energy characteristics which are typically much higher than that of the background noise. Moreover, the inventive PBAs take advantage of the bandwidth limitation effects introduced by the receiving filter which are inherent to these systems. The described new methods detect each pulse position of impulsive noise from the received time domain OFDM signals by using a threshold and a proper detection rule, and clear these samples to zero, thereby effectively filtering the OFDM signals for further use. The inventive methods are virtually unaffected by operation of the A/D converter. Moreover, the inventive methods are low cost with respect to complexity like the traditional INC methods in the time domain, but the methods detect impulsive noise positions much more accurately, thereby providing better performance. These results have not heretofore been achieved in the art.

There have thus been described certain preferred embodiments of INC methods and systems provided in accordance with the present invention. While preferred embodiments have been described and disclosed, it will be appreciated by those with skill in the art that modifications are within the true spirit and scope of the invention. The appended claims are intended to cover all such modifications.

## Claims

1. A receiver comprising:
means for receiving a source of signal having impulsive noise therein; and
means for detecting in time domain a position of the impulsive noise in the signal and clearing the impulsive noise from the signal based on the position of the impulsive noise.

2. The receiver recited in claim 1, wherein the detecting means comprises a first circuit for examining a threshold.

3. The receiver recited in claim 2, further comprising a second circuit in communication with the first circuit for clearing the signal based on the threshold.

4. The receiver recited in claim 3, wherein the second circuit comprises a digital clearing circuit.

5. A method, comprising the steps of:
detecting in time domain a position of impulsive noise in a signal;
evaluating the position of the impulsive noise in the signal; and
clearing the signal of the impulsive noise based on the evaluation.

6. The method recited in claim 5, wherein the detecting step further comprises the step of detecting a threshold in the signal.

7. The method recited in claim 6, further comprising the step of detecting samples of impulsive noise in the signal that exceed the threshold.

8. The method recited in claim 7, wherein the step of detecting samples comprises applying a detection rule.

9. The method recited in claim 8, wherein the applying step comprises determining whether the detection rule is satisfied for pulses exceeding the threshold.

10. The method recited in claim 6, wherein the step of detecting a threshold comprises the steps of :
determining a dynamic range of the signal; and
setting the threshold based on the dynamic range.

11. The method recited in claim 10, wherein the step of setting the threshold comprises setting the threshold, Th, to αAd, wherein α is a constant relating to the signal and Ad is the dynamic range of the signal.

12. The method recited in claim 11, wherein the applying step comprises the steps of:
determining parameters of the signal;
determining whether the signal exceeds the threshold based on the parameters; and
clearing the signal of the noise when the threshold is exceeded.

13. An impulsive noise cancellation circuit comprising:
a first circuit for determining in the time domain parameters of a signal having impulsive noise therein;
a second circuit adapted to receive data relating to the determined parameters for determining a position of the impulsive noise in the signal and for clearing the impulsive noise from the signal based on the parameters.

14. The impulsive noise cancellation circuit recited in claim 13, wherein the first circuit comprises an integrated circuit that is adapted to determine energy content of the impulsive noise as at least one of the parameters and a threshold for clearing the impulsive noise from the signal when the energy content is above the threshold.

15. The impulsive noise cancellation circuit recited in claim 14, wherein the second circuit comprises a digital clearing circuit.
